(19) **Europäisches Patentamt**

**European Patent Office**

**Office européen des brevets**

(11) **EP 1 094 622 A1**

(12) **EUROPEAN PATENT APPLICATION**

(43) Date of publication:
25.04.2001 Bulletin 2001/17

(51) Int. Cl.[7]: **H04B 7/26**, H03J 7/02, H03L 1/00, H04B 7/01

(21) Application number: 99870215.3

(22) Date of filing: 18.10.1999

(84) Designated Contracting States:
**AT BE CH CY DE DK ES FI FR GB GR IE IT LI LU MC NL PT SE**
Designated Extension States:
**AL LT LV MK RO SI**

(71) Applicant: **Sait Devlonics N.V.**
**8500 Kortrijk (BE)**

(72) Inventor: **Deman, Ivan**
**1180 Bruxelles (BE)**

(74) Representative:
**Gevers, Florent et al**
**Gevers & Vander Haeghen,**
**Patent Attorneys,**
**Rue de Livourne 7**
**1060 Brussels (BE)**

(54) **Method for determining the frequency error on a local oscillator of a terminal**

(57)     A method is disclosed for determining the frequency error on a local oscillator of a terminal provided to receive a signal from a transmitter in relative movement with respect to the terminal, in particular a satellite. The method comprises the steps of measuring a characteristic frequency and a temporal variation of the characteristic frequency as seen by the terminal from a signal transmitted from the transmitter to the terminal; and determining the local oscillator frequency error from a functional relation between the measured characteristic frequency and the local oscillator frequency error.

EP 1 094 622 A1

**Description**

The present invention relates to a method for determining the frequency error on a local oscillator of a terminal provided to receive a signal from a transmitter in relative movement with respect to the terminal, in particular a satellite.

In a communication system between a satellite and a terminal, a terminal being any ground communication equipment in a satellite based system, it is important that the terminal's clock is correctly calibrated with respect to the satellite clock, for obtaining a good up-link communication, i.e. a communication link from the terminal to the satellite. Typically, for improving up-link communication, one will use terminals having a more precise clock. This solution drastically increases the costs of a satellite based communication system.

The object of the invention is to calibrate the local oscillator of a terminal by determining the error on the local oscillator using only the down-link signal from the transmitter, i.e. the signal coming from the transmitter to the terminal, without any a priori knowledge of the terminal's own geo-location.

This object is achieved with the method according to the invention, which comprises the steps of measuring a characteristic frequency and a temporal variation of the characteristic frequency as seen by the terminal from a signal transmitted from the transmitter to the terminal; and determining the local oscillator frequency error from a functional relation between the measured characteristic frequency and the local oscillator frequency error.

In particular, the characteristic frequency is the RF frequency and the following functional relation is used :

$$(\hat{f}+LO)^4 + (\hat{f}+LO)^3 \frac{2\hat{f}''}{\omega_s^2} + (\hat{f}+LO)^2 \left( \left(\frac{\hat{f}''}{\omega_s}\right)^2 + \frac{3}{2}\left(\frac{\hat{f}'}{\omega_s}\right)^2 - \frac{A}{2} \right)$$

$$-(\hat{f}+LO)\frac{\hat{f}''}{\omega_s^2}\left( A + 3\left(\frac{\hat{f}'}{\omega_s}\right)^2 \right) - \frac{A}{2}\left(\frac{\hat{f}''}{\omega_s^2}\right)^2 = 0$$

wherein:

$\hat{f}$ is the reduced RF frequency offset, i.e. the RF frequency offset divided by the nominal frequency;
$\hat{f}'$ is the first derivative of the reduced RF frequency offset;
$\hat{f}''$ is the second derivative of the reduced RF frequency offset;
$\omega_s$ is the angular speed of the satellite (for a nearly circular orbit);
A is a dimensionless constant equal to $(P^2 + S^2)\omega_s^2 / c^2$ with P the distance between the earth centre and the terminal, S the distance between the earth centre and the satellite and c the speed of light; and
LO is the local oscillator reduced frequency error.

The invention will now be described in detail referring to the annexed figure, showing a graph of the functional relation between the Doppler and its first and second derivatives.

The method according to the invention is applicable to a satellite system having at least one satellite and one terminal. Suppose that a down-link is established from the satellite and the terminal and that the terminal is able to track the down-link signal. The RF carrier frequency offset seen by the terminal is composed of: the error on the terminal local oscillator and the variable Doppler shift due to the relative movement of the satellite with respect to the terminal.

The method described has as object the determination of the error on the local oscillator of the terminal by matching to the expected Doppler curve.

The invention is applicable to all cases where the satellite transmits a signal (direct generation, transponder, regenerative transponder, etc.). In the case a transponder is used, a Doppler compensation mechanism has to be used on the up-link between the ground station and the satellite, or the terminal has to know the position of the ground station and of the satellite, in order to compute the Doppler effects in the up-link.

To understand the meaning of the equations described further, the following definitions are given.

$\mathbf{x}$ (bold) : 3-D vector in inertial co-ordinate system, for example (e.g. ECI, Earth Centred Inertial);
$\mathbf{x} \wedge \mathbf{y}$ : vector product of vectors $\mathbf{x}$ and $\mathbf{y}$;
$\mathbf{x}.\mathbf{y}$ or $\mathbf{xy}$ : scalar product of vectors $\mathbf{x}$ and $\mathbf{y}$;
$\omega_e$ : angular speed vector of the earth;
$\omega_s$ : angular speed vector of the satellite (for nearly circular orbit);
$\mathbf{s}, \mathbf{s}', \mathbf{s}'', \mathbf{s}'''$ : satellite radius vector and its derivatives;

**p, p', p'', p'''**: terminal radius vector and its derivatives;

P : |**p**|, i.e. the length of vector **p**;

S : |**s**|, i.e. the length of vector **s**;

d, d', d'', d''' : satellite to terminal range and derivatives;

c : speed of light;

*f, f', f''* : reduced Doppler shift and derivatives

$$\text{(i.e. } f = -d'/c; \; f' = -d''/c; \; f'' = -d'''/c).$$

By successive differentiation, it is determined that :

$$d^2 = (p - s)^2$$

$$dd' = (p - s)(p' - s')$$

$$dd'' + d'^2 = (p - s)(p'' - s'') + (p' - s')^2$$

$$dd''' + 3d'd'' = (p - s)(p''' - s''') + 3(p' - s')(p'' - s'')$$

For a nearly circular orbit, and neglecting the Earth's rotation, the following equations can be used.

$$d^2 = (p - s)^2 \qquad \text{[Equation 1]}$$

$$dd' = -p(\omega_s \wedge s) \qquad \text{[Equation 2]}$$

$$dd'' + d'^2 = \omega_s^2(ps) \qquad \text{[Equation 3]}$$

$$dd''' + 3d'd'' = \omega_s^2 \, p(\omega_s \wedge s) \qquad \text{[Equation 4]}$$

By elimination of $\{p(\omega_s \wedge s)\}$ in equations 2 & 4, and by elimination of $\{ps\}$ in Equations 1 & 3, the following equations are obtained.

$$\frac{\omega_s^2}{c^2}\left(P^2 + S^2\right) - 2f^2 = \frac{3ff'^2\left(\omega_s^2 f - 2f''\right)}{\left(\omega_s^2 f + f''\right)^2} \qquad \text{[Equation 5]}$$

$$d = 3c\frac{ff'}{\omega_s^2 f + f''} \qquad \text{[Equation 6]}$$

Equation 5 can be transformed into a 4$^{th}$ order polynomial equation in {f}. Introducing the dimensionless constant $A = (P^2 + S^2)\omega_s^2 / c^2$, the following equation is obtained.

$$f^4 + f^3 \frac{2f''}{\omega_s^2} + f^2\left(\left(\frac{f''}{\omega_s^2}\right)^2 + \frac{3}{2}\left(\frac{f'}{\omega_s}\right)^2 - \frac{A}{2}\right) - f\frac{f''}{\omega_s^2}\left(A + 3\left(\frac{f'}{\omega_s}\right)^2\right) - \frac{A}{2}\left(\frac{f''}{\omega_s^2}\right)^2 = 0$$

[Equation 7].

This functional relation is graphically shown in the annexed Figure.

Assuming the local oscillator error to be constant, its effect vanishes in the differentiation process. If $\{\hat{f}'\}$ and $\{\hat{f}''\}$ are the measured estimates for $\{f'\}$ and $\{f''\}$, equation 7 or the annexed figure yield the theoretical current reduced Doppler shift $\{f\}$. The local oscillator error (LO) is the difference between that theoretical reduced Doppler shift and the measured reduced RF frequency offset or $(f - \hat{f})$. Thus

$$LO = f - \hat{f} \qquad \text{[Equation 8]}$$

Eliminating f in equation 7 using equation 8 gives the following equation.

$$\left(\hat{f} + LO\right)^4 + \left(\hat{f} + LO\right)^3 \frac{2\hat{f}''}{\omega_s^2} + \left(\hat{f} + LO\right)\left(\left(\frac{\hat{f}''}{\omega_s^2}\right)^2 + \frac{3}{2}\left(\frac{\hat{f}'}{\omega_s}\right)^2 - \frac{A}{2}\right)$$

$$-\left(\hat{f} + LO\right)\frac{\hat{f}''}{\omega_s^2}\left(A + 3\left(\frac{\hat{f}'}{\omega_s}\right)^2\right) - \frac{A}{2}\left(\frac{\hat{f}''}{\omega_s^2}\right)^2 = 0$$

[Equation 9]

It should be noted that equations 7 and 8 or equation 9 gives more than a single result. In most of the cases, only one result has a practical meaning. In case there is more than one meaningful result, an additional set of measurements is taken and additional values of the local oscillator error will be determined. This allows resolving the uncertainty.

For a low Earth orbiting satellite, the height being approximately 800 Km, the annexed figure represents the functional relation (curve family with steps of 1 ppm). The accuracy of the method depends on

- the satellite's orbital elements
- the accuracy on the frequency offset measurement

The approximation consisting in neglecting the Earth's rotation has an impact on the accuracy which depends on the satellite orbit.

The accuracy on the local clock error estimation can be determined with the following 4 sets of parameters (measured reduced frequency shift and derivatives):

$\{\hat{f}, \hat{f}' + \Delta f', \hat{f}'' + \Delta f''\}$
$\{\hat{f}, \hat{f}' + \Delta f', \hat{f}'' - \Delta f''\}$
$\{\hat{f}, \hat{f}' - \Delta f', \hat{f}'' + \Delta f''\}$
$\{\hat{f}, \hat{f}' - \Delta f', \hat{f}'' - \Delta f''\}$

where $\Delta f'$ & $\Delta f''$ are for example the standard deviation on the estimators.

If the four values of the local oscillator error estimation are within an acceptable range, the calibration procedure is considered as successful.

The values $\hat{f}$, $\hat{f}'$ and $\hat{f}''$ are in particular determined on the basis of carrier phase measurements. From an available set of contiguous discrete time measurements of the phase provided by the terminal's demodulator, an approximation of the phase is determined in the form of a polynomial. The regression polynomial has a determined order, in particular the third order for a polynomial of phase measurements. For a polynomial on the basis of frequency values, a second order polynomial could for example be used. These techniques of polynomial determination are known as such and will therefore not be described in detail.

From the third order polynomial of phase measurements, the measured reduced frequency offset and derivatives $\hat{f}$, $\hat{f}'$ and $\hat{f}''$ can be determined by successive derivations and reduction.

It should be noted that another characteristic frequency of the down-link signal could also be used, such as chip frequency in a CDMA system, symbol rate, bit rate, ...

Further, instead of determining the frequency and its first and second derivatives at one time for determining the local oscillator error, some sampling of the averaged frequency at regular intervals could be used, or sampling of the instantaneous phase. In those cases, other equations than equation 9 will be used.

In particular, if three frequency values $\hat{f}_0$, $\hat{f}_1$ and $\hat{f}_2$ are measured, with a time interval T between each measurement, the terms $\hat{f}$, $\hat{f}'$ and $\hat{f}''$ in equations 7 and 9 could be replaced with the following equations.

$$\hat{f} = \hat{f}_1 \qquad \text{[Equation 10]}$$

$$\hat{f}' = \frac{\hat{f}_2 - \hat{f}_0}{2T} \qquad \text{[Equation 11]}$$

$$\hat{f}'' = \frac{\hat{f}_2 - 2\hat{f}_1 + \hat{f}_0}{T^2} \qquad \text{[Equation 12]}$$

This leads to new equations from which the local oscillator error can be determined. Additional correction factors could however be used for increasing the accuracy.

In general, the local oscillator error can be determined either exactly from the equations, or approximated using some gradient algorithm, simulation, iterative method or maximum likelihood method.

Experiments have been done applying the method according to the invention with a satellite transmitting at an RF frequency equal to 400.6 MHz The measured RF frequency offset was equal to -6009 Hz, the first derivative -36.05 Hz/s and the second derivative 0.4014 Hz/s$^2$. The reduced frequency offsets and derivatives are obtained by division of the measured values with the RF frequency, i.e. 400.6 MHz. The following values are thus obtained :

$\hat{f}$ = -15.00 $10^{-6}$
$\hat{f}'$ = 9.00 $10^{-8}$/s
$\hat{f}''$ = 10.02 $10^{-10}$/s$^2$

Solving equation 9 leads to a local oscillator frequency error LO equal to 1.00 $10^{-6}$.

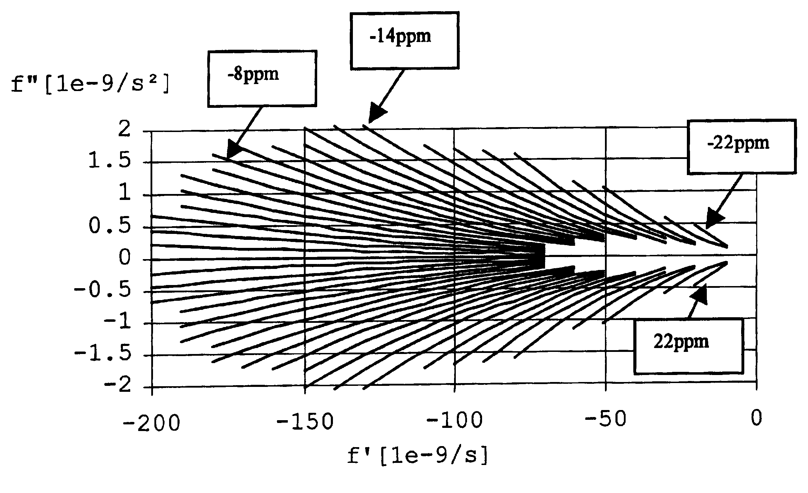

**Claims**

1. A method for determining the frequency error on a local oscillator of a terminal provided to receive a signal from a transmitter in relative movement with respect to the terminal, in particular a satellite, the method comprising the steps of:

   a) measuring a characteristic frequency and a temporal variation of the characteristic frequency as seen by the terminal from a signal transmitted from the transmitter to the terminal;
   b) determining the local oscillator frequency error from a functional relation between the measured characteristic frequency and the local oscillator frequency error.

2. The method according to claim 1, wherein the characteristic frequency is the RF frequency.

3. The method according to claim 1 or 2, wherein the functional relation is equal to :

$$\left(\hat{f}+LO\right)^{4}+\left(\hat{f}+LO\right)^{3}\frac{2\hat{f}''}{\omega_{s}^{2}}+\left(\hat{f}+LO\right)\left[\left(\frac{\hat{f}''}{\omega_{s}^{2}}\right)^{2}+\frac{3}{2}\left(\frac{\hat{f}'}{\omega_{s}}\right)^{2}-\frac{A}{2}\right]$$

$$-\left(\hat{f}+LO\right)\frac{\hat{f}''}{\omega_{s}^{2}}\left(A+3\left(\frac{\hat{f}'}{\omega_{s}}\right)^{2}\right)-\frac{A}{2}\left(\frac{\hat{f}''}{\omega_{s}^{2}}\right)^{2}\simeq 0$$

wherein :

$\hat{f}$ is the reduced RF frequency offset;
$\hat{f}'$ is the first derivative of the reduced RF frequency offset;
$\hat{f}''$ is the second derivative of the reduced RF frequency offset;
$\omega_{s}$ is the angular speed of the satellite (for a nearly circular orbit);
A is a dimensionless constant equal to $(P^2 + S^2)\omega_s^2 / c^2$ with P distance between the earth centre and the terminal, S the distance between the earth centre and the satellite and c the speed of light; and
LO is the local oscillator frequency error.

4. The method according to claim 3, wherein the frequency offset is determined by derivation of the carrier phase.

5. The method of claim 4, wherein the carrier phase is determined by polynomial regression of the instantaneous phase.

6. The method of claim 3, wherein the carrier phase is determined by polynomial regression of the instantaneous frequency.

-22ppm

22ppm

-14ppm

-8ppm

f'[1e-9/s]

f"[1e-9/s²]

2   1.5   1   0.5   0   -0.5   -1   -1.5   -2

0   -50   -100   -150   -200

**European Patent Office**

**EUROPEAN SEARCH REPORT**

Application Number

EP 99 87 0215

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 96 08882 A (ERICSSON GE MOBILE INC) 21 March 1996 (1996-03-21) | 1,2 | H04B7/26 H03J7/02 |
| A | * page 6, line 21 - page 9, line 23; figure 4 * | 3-6 | H03L1/00 H04B7/01 |
| X | US 5 934 606 A (GUILD JOSEPH R) 10 August 1999 (1999-08-10) * the whole document * | 1,2 | |
| A | EP 0 848 509 A (ALSTHOM CGE ALCATEL) 17 June 1998 (1998-06-17) * the whole document * | | |
| A | US 5 613 193 A (ISHIKAWA HIROYASU ET AL) 18 March 1997 (1997-03-18) * the whole document * | | |

TECHNICAL FIELDS SEARCHED (Int.Cl.7)

H04B
H03J
H03L

The present search report has been drawn up for all claims

| Place of search | Date of completion of the search | Examiner |
|---|---|---|
| MUNICH | 22 February 2000 | Kahn, K-D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

## ANNEX TO THE EUROPEAN SEARCH REPORT
## ON EUROPEAN PATENT APPLICATION NO.

EP 99 87 0215

This annex lists the patent family members relating to the patent documents cited in the above–mentioned European search report.
The members are as contained in the European Patent Office EDP file on
The European Patent Office is in no way liable for these particulars which are merely given for the purpose of information.

22-02-2000

| Patent document cited in search report | | Publication date | Patent family member(s) | | Publication date |
|---|---|---|---|---|---|
| WO 9608882 | A | 21-03-1996 | US | 5742908 A | 21-04-1998 |
| | | | AU | 693272 B | 25-06-1998 |
| | | | AU | 3729695 A | 29-03-1996 |
| | | | BR | 9506495 A | 07-10-1997 |
| | | | CA | 2174938 A | 21-03-1996 |
| | | | CN | 1135813 A | 13-11-1996 |
| | | | EP | 0728385 A | 28-08-1996 |
| | | | FI | 962027 A | 13-05-1996 |
| | | | JP | 9510067 T | 07-10-1997 |
| US 5934606 | A | 10-08-1999 | BR | 9805793 A | 23-11-1999 |
| EP 0848509 | A | 17-06-1998 | FR | 2757339 A | 19-06-1998 |
| | | | CA | 2222408 A | 12-06-1998 |
| | | | JP | 10200471 A | 31-07-1998 |
| US 5613193 | A | 18-03-1997 | JP | 2953260 B | 27-09-1999 |
| | | | JP | 7022990 A | 24-01-1995 |

EPO FORM P0459

For more details about this annex : see Official Journal of the European Patent Office, No. 12/82